Europäisches Patentamt

(19) European Patent Office

Office européen des brevets

(11) Publication number: **0 108 616**
**B1**

(12) **EUROPEAN PATENT SPECIFICATION**

(45) Date of publication of patent specification: **10.02.88**

(21) Application number: **83306704.4**

(22) Date of filing: **03.11.83**

(51) Int. Cl.⁴: **C 03 C 17/23,** C 03 C 17/27, C 03 B 23/023, C 23 C 14/34, H 05 B 3/26

(54) A process for making an electrically conductive coated substrate.

(30) Priority: **03.11.82 US 438789**

(43) Date of publication of application: **16.05.84 Bulletin 84/20**

(45) Publication of the grant of the patent: **10.02.88 Bulletin 88/06**

(84) Designated Contracting States: **BE DE FR GB SE**

(56) References cited:
DE-B-2 441 862
GB-A- 739 565
GB-A-2 094 355
US-A-3 655 545

(73) Proprietor: **DONNELLY MIRRORS, INC.**
**49 West Third Street**
**Holland Michigan 49423 (US)**

(72) Inventor: **Bitter, Lowell Edward**
**15875 Ransom Street**
**Holland Michigan 49423 (US)**

(74) Representative: **Robinson, Anthony John Metcalf et al**
**Kilburn & Strode 30 John Street**
**London, WC1N 2DD (GB)**

The file contains technical information submitted after the application was filed and not included in this specification

Courier Press, Leamington Spa, England.

## Description

This invention relates to a process for making an electrically conductive coated substrate and to substrates so coated.

This invention is particularly suitable for producing a curved glass member having a transparent, electroconductive coating. Such a member is particularly adapted for use in heating applications at relatively low voltages. Such glass might be used for CRT screens which can input by touching, architectural glass (since such coatings are infrared reflective), curved, heated mirrors, and heated windows.

One possible application for such a product is automotive windshields. By applying a current to such windshields, accumulated frost, ice or fog can be removed by heating. It has been found that one should be able to generate 930 Wm$^{-2}$ (0.6 watts per square inch) within a windshield of typical shape, with a space of 0.635 m (25″) between the electrical bus bars, in order to clear rime ice 2.54 mm (0.1″) thick in about five minutes. Using a 60 volt auxiliary power source, which systems are readily available for use in automobiles, this means that the sheet resistivity of any coating on the glass must only be about 10 ohms per square sheet.

A light transmissibility standard of a 70% minimum visible light transmission at an angle of 90° to the glass surface is required in some countries. Further, the electroconductive coating used, in order to be suitable in appearance, must be very thin, uniform, low in absorption, and low in reflection. These constraints make it particularly difficult to achieve such low resistivity. Assuming a coating with a range of refractive index of 1.6 to 2.1, as is the case with indium-tin oxide coatings, a nominal full wave coating would have a physical thickness of approximately 340 nm to 260 nm (3,400 to 2,600 angstroms) (i.e., the median wave length for visible light, 550 nm (5,500Å), divided by the refractive index).

There are known commercially viable techniques available for satisfactorily providing curved glass uniformly coated with such a thin film having such a low resistivity, and such a process is needed. It is known to put transparent conductive coatings on aircraft windows, display cases and the like. Generally, however, flat glass is used in such applications. Also, high voltage power sources are available in such environments so that a high resistance in the film coating can be tolerated.

A technique for preparing aircraft windows with electrically conductive coatings is to coat the hot surface of the glass with a tin oxide deposited pyrolytically. US—A—2,954,454 describes such a method for creating a coated, bent glass windshield. The problem with such a system is that in order to achieve coatings which make it possible to deliver 930 Wm$^{-2}$ (0.6 watts per square inch) at low voltages, i.e., about 60 volts, one must provide a relatively thick film of between 500 nm and 1,000 nm (5,000 and 10,000 angstroms). This results in a windshield or curved glass article which yields a "rainbow" of reflected colour when exposed to light. This is partially due to the thickness of the coating, partially to the high index of refraction of tin oxide, and partially to the inherent non-uniform thickness of pyrolytically deposited tin oxide. Also it is suspected that such a process will yield a coating which will craze when the glass is bent, at least if produced on an economical commercial basis and using conventional bending procedures.

Indium-tin oxide has heretofore been sputter coated onto flat glass for use in liquid crystal display electrodes. However, when processed in accordance with conventional procedures, such indium-tin oxide, sputter coated flat glass cannot be bent on a viable production basis without crazing the indium-tin oxide coating. Such crazing of course interrupts the conduction of electricity and leads to serious imperfections in the heating pattern in the product.

UK—A—1,446,849, describes the sputter coating of an already curved sheet of glass. Such a process would be very slow, and uniformly is believed to be a serious problem. It is not believed that such a process would be acceptable in commercial production.

As a result of such drawbacks, it is believed that heretofore there has not been commercially produced electrically conductive curved parts for low voltage by glass coating processes. Further, even alternatives other than coating the glass, such as embedded wires or embedded conductively coated plastic films, have not proven commercially acceptable for heating applications where visibility is primary.

According to a first aspect of the present invention a process for making an electrically conductive bent substrate is characterised by coating a generally flat part with indium tin oxide and subsequently bending the part while providing for at least sufficient oxygen substoichiometry at the moment of bend that there is substantially no crazing of the coating during bending, but not so great a substoichiometry that the final product has less than 70% light transmission, at an angle of 90° to the substrate, or is substantially hazy. The present invention also extends to the product of the process.

The substrate is preferably glass and the bending step is preferably conducted at typical heating and bending rates for such glass. Thus the present invention can be used to coat flat glass with indium-tin oxide, and it enables the glass to be bent without crazing the coating to produce a curved part which can be designed to yield a power density satisfactory to achieve heating with a low voltage source, and having acceptable light transmission, absorption and reflective properties.

The process according to the present invention may be achieved on a commercially acceptable basis, both in terms of repeatability and in terms of time constraints.

The substoichiometry may be achieved by exposing the metallic oxide layer to a reducing environment as the substrate is heated to bend it.

There may be a reduction curing step in which the coated substrate is exposed to a reducing environment at a temperature in excess of 400°C. This step is conveniently carried out after bending. However, if the indium-tin oxide layer is exposed to a reducing environment as the substrate is heated to bend it, then this curing step can be said to be incorporated in the bending step.

According to a second aspect of the present invention there is provided a process for enhancing the electrical conductivity of an indium tin oxide coating coated on a substrate, characterised by first firing the coated substrate in atmosphere to a temperature in excess of about 500°C. but below the softening point of the glass, followed by bending the substrate, and heating the coating to a temperature greater than 400°C. in a reducing environment for a sufficient period of time to substantially lower the electrical resistance of the coating.

Such a process produces very low resistance in relatively thin films. Curing the coated substrate in a reducing environment at a temperature greater than 400°C. is a temperature far in excess of those heretofore thought acceptable. Such curing increases light absorption in the resulting curved part which acts to reduce reflection without unduly interfering with the high level of light transmission which has been achieved by the present invention.

In a preferred embodiment the coated substrate is heated in the presence of a mildly reducing gas to approximately 440°C. and held there for approximately 20 minutes.

A suitable coating method for both the first and second aspects of the invention is sputter coating. The sputter coating can be carried out on an unheated substrate or a heated substrate.

The coating may be achieved by sputter coating a heated substrate with the indium-tin oxide in a reduced oxygen environment to an initial light transmittance of between 10 and 75%, and avoiding complete oxidation thereafter at least until after the substrate is bent. Preferably the substrate is coated to an initial light transmittance in excess of about 40%. Even more preferably the initial light transmittance is in excess of 60%.

Alternatively, the coating may be achieved by sputter coating a substantially unheated substrate with the metallic oxide in a reduced oxygen environment to an initial light transmittance of between 10 and 40%, and avoiding complete oxidation hereafter at least until after the substrate is bent.

The coated substrate is preferably heated in an oxidizing environment sufficiently to lower the level of light absorption to between 1.7 and 10%.

The reduction step is preferably performed for sufficient time to give the coating a specific resistivity of less than $3\times10^{-6}$ ohm metres ($3\times10^{-4}$ ohm cm). Conveniently the coating has a thickness of between one-half and three wavelengths based on the median wavelength of visible light and in a preferred embodiment the coating has a thickness of between one-half and one and a half wavelengths based on the median wavelength of visible light and is preferably an integral multiple of one-half of the nominal or median wavelength of visible light.

The invention may be put into practice in various ways but two processes embodying the invention will now be described by way of example with reference to the accompanying drawings, in which:

Figure 1 is a schematic representation of a planar magnetron sputter coating apparatus of a type which can be used in this invention;

Figure 2 is a flow chart showing the process steps in one process;

Figure 3 is a flow chart showing the steps in a second process; and

Figure 4 shows schematically a glass bending frame and oven.

The process steps are followed which try to ensure that the coated indium-tin oxide layer, on a sheet of flat substrate such as glass will have sufficient substoichiometry at the moment of bending to prevent the coating from crazing. The manner in which this is achieved is probably not critical. Two alternative processes for achieving this result commercially are now described as examples of how the present invention may be effected.

Each of these processes includes a step of curing the coated glass by heating in a reducing environment (an inert gas, a reducing gas, or a vacuum environment) to temperatures far in excess of those heretofore thought acceptable. This enables the conductivity of the coating to be substantially increased without adversely affecting light transmission to a significant extent. Indeed while absorption may be higher than encountered in prior art reducing techniques, as for example described in US—A—3,655,545 the degree of light reflection is less, resulting in less glare.

A first process uses a reduced oxygen environment and sputter coats an unheated substrate to an initial light transmittance ($T_o$) of no more than about 40%. In the case of a heated substrate, $T_o$ may be greater, i.e., as much as about 75%. Both of these are significantly less than the typical 60% for an unheated substrate or typically 87% plus for a heated substrate which have been previously sought.

Using an unheated substrate there appears to be less haziness in the final product in the process of the present invention.

A reduced $T_o$, enables the coated glass to be bent without crazing, even though considerable oxidation takes place when the glass is fired prior to bending. The firing step increases light transmission nominally to 85% for a full wave coating. This indicates that some oxidation has occurred. Yet, the parts still have sufficient substoichiometry at the moment of bending that they can be bent without crazing. If the parts are sputter coated in more oxygen using this process so that $T_o$ exceeds 40% for a nonheated substrate or 75% for a heated substrate which has previously been the case, the coatings almost always craze during the bending step.

The present invention may be used to produce sheet of curved glass which can have a relatively thin coating, e.g., 280 nm (2,800 angstroms), and still yield desirable power density because of its resistance in the region of 10 ohm per square sheet resistance.

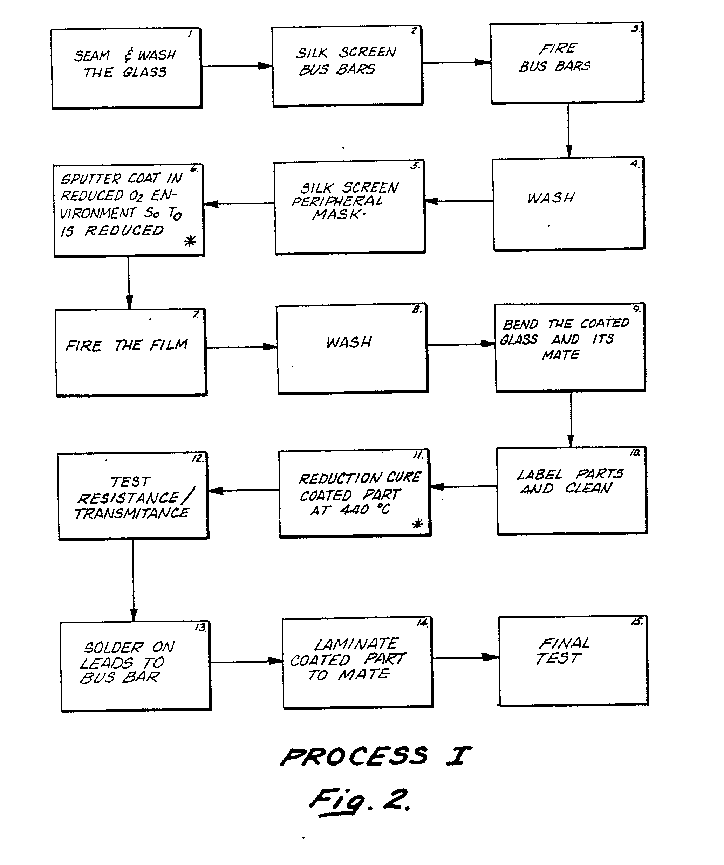

Figure 2 is a flow chart showing the basic steps employed in a first process, Process I, in which sputter coating on an unheated substrate is used as the coating process. Except for the steps indicated by an asterisk, (Steps 6 and 11 in Process I) the process steps are generally carried on in a known manner.

Step 1 Figure 2, of the process involves seaming and washing the long, cut part which is to be coated. A slightly shorter part is provided as the mate for the part to be coated and is similarly seamed and washed.

Step 2 involves silk screening electrically conductive bus bars along the top and bottom edges of the long flat piece of seamed glass to be coated. This is followed by the step of firing the bus bars in a known firing oven (step 3). The part is again washed (step 4) and is ready for step 5 in which a peripheral zone mask is silk screened onto the part. This is a known paint mask, and is intended to prevent the peripheral edges of the glass from becoming coated with a conductive film. This·prevents the conductive element from being accidentally grounded onto any contiguous conductive material.

Step 6 involves sputter coating the unheated long glass part to be coated to the desired thickness in a partial oxygen atmosphere so that the initial light transmittance, $T_o$ (illuminant A) is less than about 40%, which is significantly less than previously used. Planar magnetron sputtering is a suitable known coating method. Planar magnetron sputtering as a coating method is described in "Planar Magnetron Cathodes—Past, Present, and Future", Theodore Van Vorous, published by Vac-Tec Systems, Inc., Boulder, Colorado; US—A—4,046,659; US—A—4,022,947; CA—A—566,773.

Sputter coating is typically carried out on either an unheated substrate or on a heated substrate. Using a heated substrate, i.e., one heated to around 200°C., the processor seeks to create a completely transparent, coated glass substrate in a single step. Thus, the processor is seeking a substrate with an initial light transmission $(T_o)$ in excess of about 87%. In the present process a significantly lower $T_o$ is sought using a heated substrate. Sputter coating on an unheated substrate requires the use of two steps to get to the same point. The substrate has heretofore been coated to an initial light transmittance which is in excess of 50%, typically around 60 to 70%. The present processes seeks a significantly lower $T_o$. In order to increase the light transmittance, a subsequent oxidation step is employed (see CA—A—566,773).

In typical cathodic sputtering processes, a high negative potential is applied to a cathode assembly which is comprised of the metal(s) sought to be deposited on a substrate, typically glass. The substrate is located in the vicinity of and substantially parallel to the cathode assembly in a vacuum chamber with a low pressure, of about $6.7 \times 10^{-4}$ kpa (about $5 \times 10^{-3}$ torr), atmosphere of oxygen and inert gas such as neon, argon, krypton or xenon. The high potential and reduced pressure cause a glow discharge between the cathode and the anode. Under such conditions, the gas is energized and the gaseous ions strike the cathode causing metal ions to be ejected from the cathode and deposited on the surface of the substrate. This process is enhanced where a magnetic field is present which magnetically confines the glow discharge plasma, (i.e., a planar magnetron is employed).

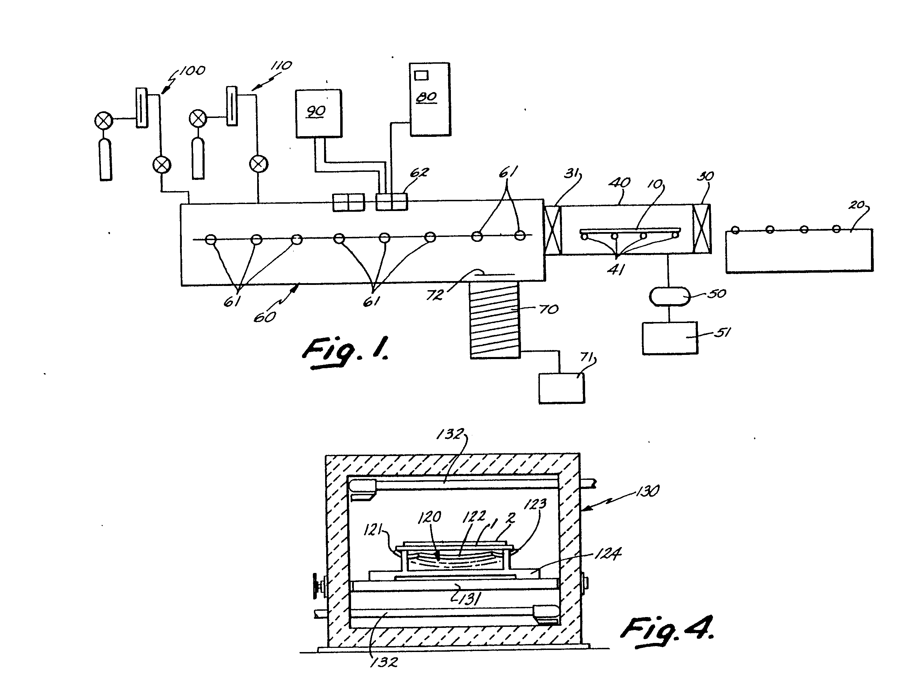

Figure 1 shows schematically a typical planar magnetron sputtering apparatus of the type which can be used in the process of the present invention. The part to be coated is placed on a tray 10, located initially on a feed table 20, and is passed through an open gate valve 30 into a load lock 40 having a second gate valve 31 at its other end. A vacuum booster 50 and backing pump 51 are used to evacuate the load lock 40 with both gate valves 30 and 31 closed. When the desired vacuum is achieved, the load lock 31 is opened and the tray 10 carrying the part to be coated is transported into the evacuated sputtering chamber 60, from one set of motor driven rollers 41 onto another set of motor driven rollers 61.

The vacuum is maintained within the sputtering chamber 60 at all times during operation by means of a diffusion pump 70 and a backing pump 71. A throttle 72 is typically used to help control the vacuum. The tray 10 and the part it carries are passed back and forth on the motorized rollers 61 beneath the sputtering target or cathode assembly 62 for as many times as is necessary to coat the part to a desired thickness.

Power to the cathode or target 62 is provided by a power supply 80. The target 62 is cooled through a regenerative water cooling system 90. Argon and oxygen are supplied to the sputtering chamber 60 by assemblies 100 and 110 respectively.

The composition of the indium-tin cathode 62 is known. A tin level of from 1 to 25% is typical, with 9% or 10% optimum. A 10% tin, 90% indium target is particularly suitable in the present case.

The degree of light transmission of the coating, after the sputtering process is complete, is a function of the extent to which the metal has been oxidized as it coats the glass substrate surface. This degree of oxidation is in turn controlled by the relative amount of oxidizer and reaction activating influences (such as substrate biasing, e.g., positive, negative, R.F.) available in the vacuum chamber. In the present case the amount of oxygen and the extent of oxidation is reduced so that the initial light transmittance, $T_o$, for an unheated substrate, is less than about 40%, (less than about 75% for a heated substrate) and the coated part can subsequently be bent without crazing the coating.

To produce acceptable parts with respect to heating uniformity and appearance, it is also important that the indium-tin oxide film be relatively uniform in thickness across the surface of the parts. Preferably, the thickness should not vary more than about ±7.5%. Such uniformity can be achieved using known sputtering techniques, particularly in view of the fact that the present invention contemplates sputter coating a flat part, rather than a curved one.

The amount of oxygen is controlled so that $T_o$ for an unheated substrate is less than about 40%, and preferably approximately 20% generally everywhere in the coating (less than 75%, preferably about 55% for a heated substrate). Naturally, some variation will be experienced, particularly with variations in film thickness. It has been found that $T_o$ can vary such as much as about ±10% across the part without undue adverse effects. $T_o$ should not be driven below about 10%, because it is too difficult to subsequently oxidize the film to yield a good, uniformly clear, haze free final product.

For purpose of clarity of the final product, the coating should be as thin as possible. Maximum transmission is achieved when the optical film thickness is an integral multiple of one-half of the nominal wavelength of visible light. Variations at other than integral multiples of half wave films will tend to reduce transmission and change the reflected colour. Using a 1.5 wavelength coating, one can achieve the desired film conductivity more easily since, for a given bulk resistivity, a thicker film will be more conductive than a thinner film. However, some light transmission is sacrificed in the final product. Going to a half wavelength coating affords some improvement in transmission, but results in a more resistive film because it is thinner (assuming everything else is constant). This makes it more difficult to achieve the ultimate desired power density. Hence a full wave coating has been found quite desirable in the present invention.

The part is passed back and forth beneath the sputtering target until the desired film thickness has been achieved. The number of passes to yield a desired film thickness will of course vary from specific apparatus to specific apparatus, and in accordance with other variations in process parameters. It has been found that variations in these parameters, and indeed, variations in the number of times that the part has to be passed beneath the sputtering target, have little or no effect on the desirability of achieving an initial $T_o$ of from about 10% to about 40% for an unheated substrate.

The desirability of achieving an initial $T_o$ of less than about 40% is relatively independent of film thickness. At a given $T_o$ of less than 40%, the bulk resistivity (or specific resistivity) achieved in the film will be approximately the same without regard to whether a full wave of 1.5 wave film is applied to the part.

The various settings for argon pressure, oxygen pressure, power density to the cathode sputtering target, and other such settings may vary from machine to machine and from procedure to procedure used in order to achieve the desired $T_o$. One of the primary factors to be controlled is the quantity of oxygen present. Further, it is perhaps significant to other operational parameters that the object of this invention is achieved primarily as a function of $T_o$, regardless of other process variations such as power density to the cathode or anode, argon pressure, or the like. Suitably the coating is deposited without auxiliary substrate heating (the sputtering process itself may warm the glass somewhat), but auxiliary heating may be used. Such heating is one example of a reaction activating influence which will modify the transmission and absorption of the as-deposited film. Such heating is likely to allow films of higher $T_o$, i.e. about 75% for substrates heated to 200°C. to survive bending without crazing. However, heating the substrate during coating is more time consuming and there is often difficulty eliminating haze from such a coating. Such heating, while allowing for an initially higher transmittance ($T_o$), does not result in a stoichiometric coating so crazing of the film at bending occurs more readily. A degree of substoichiometry at the moment of bend is necessary, which can be achieved by beginning with a $T_o$ which is lower than that previously used.

Power density to the cathode or anode can be varied as desired by the operator, for example to improve the rate of production.

After the part is coated, it is fired at approximately 540°C. (for soda lime glass) to sufficiently oxidize the film (step 7). This also oxidizes the peripheral mask. This is done in the presence of an oxidizing atmosphere, in order to oxidize the film and the mask, and takes about three to six minutes above 500°C. For temperatures less than 500°C., longer times are needed. The light transmission is increased to about 85% as a result of this step. The coated glass exhibits a light absorption of from about 1.7 to about 10% after firing. While light absorption cannot be directly correlated to the degree of substoichiometry of the film over a range of process variables, the existence of absorption of 1.7 to 10% indicates there is still oxygen substoichiometry at this point during the process. There is still sufficient substoichiometry in the coating that crazing is avoided during the subsequent bending step.

It seems to be very difficult if not impossible to over-oxidize these low $T_o$ films by firing. On repeated firings, as many as eight, the absorption has not been reduced below the range quoted above.

Step 7 would not have to be used for oxidation of the coating if the substrate were heated during coating. However, some means for removing the mask would have to be employed.

In step 8, the oxidized paint mask is removed.

As is used in such a bending process, the two pieces (1 and 2) which are to be later assembled into a single part are bent together. The longer piece 1 is typically placed on the bottom and is dusted with a suitable parting medium such as talc. The shorter piece is placed on top. The two are placed in a bending fixture 120 (Figure 4). Such fixtures are known and generally comprise several hinged segments, 121, 122, and 123 as shown in Figure 4, which in turn are hingedly mounted at some point to a base support 124. The particular shape of the hinged segments will vary depending on the final shape desired for the part. The longer flat piece 1 is placed on the fixture such that it extends between the ends thereof as generally shown in solid lines in Figure 4, with the shorter piece 2 on top. The entire fixture 120 and the parts 1 and 2 are then passed on a conveyor 131 into an oven 130. Heat is supplied by heating elements 132. The glass is heated in the oven to a temperature just sufficiently near its softening point to cause it to sag down into the hinged segments 121, 122, and 123 of the bending fixture until it comes to rest against the edges of the hinged segments 121, 122, and 123. The sagged or bent condition for the parts and the hinged segments 121, 122, and 123 is indicated in phantom lines in Figure 4.

This procedure is known and can be used in the present invention to produce an indium-tin oxide coating with little or no crazing. However, it is important that the heating parameters of a conventional glass bending procedure are not exceeded. It is typical to elevate the temperature of conventional soda lime glass to about 590°C., i.e., 40°C. below its softening point, for bends of 0.30 m to 1.525 m (12 to 60 inch) radius. This causes the glass to sag and take its shape within a few minutes of reaching this temperature.

If unusual bending procedures are followed, specifically if the temperature of the substrate is allowed to substantially exceed these ranges and near the softening point of the glass, thereby causing the glass to sag more rapidly and perhaps substantially beyond the planes defined by the edges of the bending fixture or frame 120, crazing of the indium-tin oxide coating will tend to occur.

The occurrence of this crazing is not a function of temperature per se, but of the rapidity with which the glass is caused to sag or bend. No or substantially no crazing occurs when conventional soda lime glass is heated to about 590°C., the softening point of such glass being about 630°C. At more elevated temperatures, crazing tends to occur on conventional soda lime glass.

Crazing does not occur either at all or to a significant extent (for the low $T_o$ coating) during the bending of borosilicate glass at temperatures of about 650°C. The softening point of borosilicate glass is approximately 820°C. At this temperature, the borosilicate glass bends at about the same rate as conventional glass does at 590°C. The rate at which the glass is allowed to sag or bend is thus an important parameter.

The possibility of crazing in the coating can be minimized even further by reducing the speed at which the part is allowed to bend. At very, very slow rates, even high $T_o$ coatings will not craze. However, it is impractical and uneconomical to bend at extremely slow rates.

Thus, the present invention is intended to facilitate conventional bending of the part in accordance with conventional techniques without crazing. It is significant that conventional glass bending in this way results in a part having a gradually curved surface rather than very sharp corners or radii, and it has been found that the tendency to craze is enhanced for sharp bends, e.g., less about about 0.305 m (12″) radius.

After bending, the two parts are separated labeled for later reassembly, and cleaned (step 10, Figure 2). The coated, longer part is then reduction cured (step 11, Figure 2). The coated, bent part is placed in an oven and heated to in excess of 400°C., preferably about 440°C., for about 20 minutes. Previously the maximum temperature used has been in the region of 340°C. During reduction, the part may be exposed to a mildly reducing atmosphere, consisting of about 95% nitrogen and about 5% hydrogen. Heating to this temperature in simply an inert gas such as nitrogen, or in a vacuum, will achieve the same desired result, but must be conducted for a longer period of time, approximately an hour, as opposed to 20 minutes when a reducing gas is included in the gas mixture, e.g., 5% hydrogen.

This postbend reduction step lowers the refractive index (real portion) of the indium-tin oxide (ITO) film and, it is believed, imposes an index gradient on that film, with the lowest index being at the film surface away from the glass. It also increases film absorption. For typical levels of reduction, this results in increased film absorption (about 5%) and some decrease in film reflection and transmission. The particular values will depend upon the exact film thickness and degree of reduction, but typically (for untinctured glass), the transmission would be about 86% as bent with absorption of 1%. After curing the transmission would be about 84% and absorption about 5%. However, in the final laminated product, the upper film surface contacts the plastics interlayer reducing substantially the light reflected by the film. This results in a final part with desirable optical properties, i.e., high transmission, low reflection, and a subtle reflected colour. Final transmission of about 85% is typical for single strength clear glass in a laminated unit.

Most importantly, this reduction curing step yields a coating which is highly conductive in spite of its high degree of light transmission. The sheet resistance in a full wave coating 280 nm (2,800 angstroms) thick is approximately 9 ohms per square sheet. This is a bulk or specific resistivity of only about $2.5 \times 10^{-6}$ ohm metres ($2.5 \times 10^{-4}$ ohm cm). A sheet resistivity approaching 10 ohms per square is described in US—A—3,655,545, and that was in a coating having a thickness of about 600 nm (6,000Å). This would be a specific or bulk

resistivity of approximately $6 \times 10^{-6}$ ohm metres ($6 \times 10^{-4}$ ohm cms).

After the coated part has been reduction cured, it is tested for resistance and transmittance (step 12, Figure 2). Leads are then soldered onto the previously applied bus bars (step 13). The coated part and its similarly curved mate are then laminated together in a known manner using an intermediate polybutyrate plastic sheet (step 14). After final testing, the product is ready for use and for shipment to the customer.

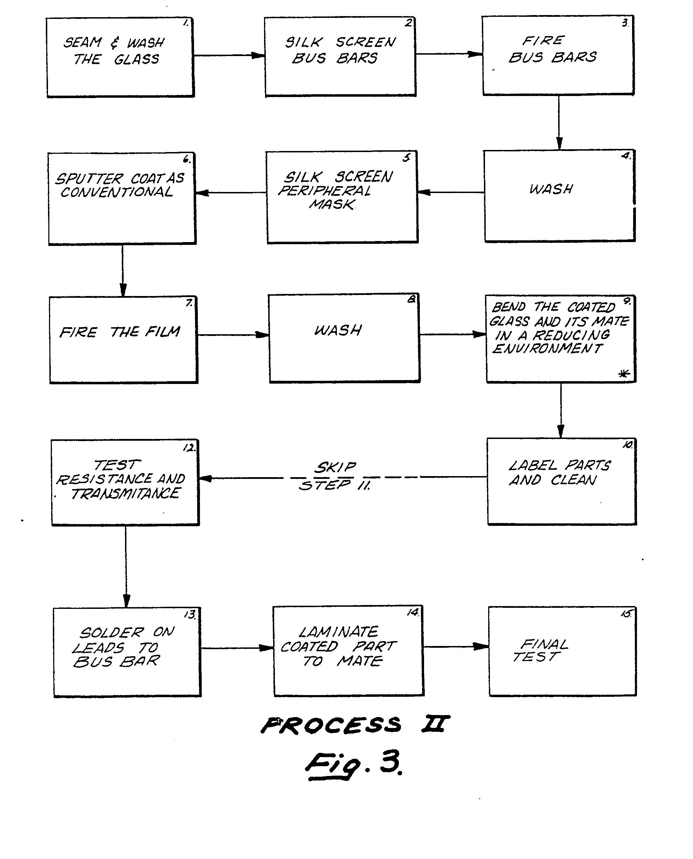

Figure 3 shows an alternative process, Process II, by which a degree of substoichiometry can be achieved in the indium-tin oxide coating at the moment of bend. The key differences between the two processes occur at steps 6 and 9, and in the elimination of step 11 from Process I. All of the other steps in the process correspond to the correspondingly numbered steps in Process I.

Referring to step 6, it will be noted that in Process II the longer part may be sputter coated as is conventional to a $T_o$ which for a nonheated substrate is in excess of about 40%. As noted previously, $T_o$ for a nonheated substrate is typically around 60% after sputtering. Thus a conventional sputter coating step is used instead of the sputtering step in a reduced oxygen environment used in Process I.

Turning to step 9, it will be noted by the asterisk in Figure 3 that in Process II, the bending step is unconventional or unusual whereas in Process I, the bending step is known or is conventional. The bending step in Process II is unconventional or unusual in that the glass and its mate are bent in a reducing environment. Further, the position of the parts should be reversed so that the indium-tin oxide coating is exposed to the reducing environment. The shorter part is therefore placed on the bottom dusted with a parting medium such as talc, and the longer, coated part is placed on top of the shorter part with its coated surface upwards.

In step 7 (assuming an unheated substrate during coating) the firing must achieve sufficient oxidation that excessive reduction does not result during the reduction bending step. The firing referred to above in connection with Process I has been found adequate for this.

The bending fixture or frame 120 with the parts arranged as described above are introduced into an oven which is preferably filled with a mildly reducing gas. The gas used in step 11 in Process I can be used in step 9 in Process II. This causes reduction of the coating as the glass is heated to bend. This ensures a degree of substoichiometry at the moment of bend and thereby prevents or substantially minimizes crazing of the coating as the part bends.

In all other respects, in terms of timing and the like, the bending process is carried on as described previously with respect to Process I. All of the other parameters discussed in connection with step 9 for Process I are applicable in step 9 for Process II.

The reducing environment in the bending step may be due to the presence of a reducing gas, as described above, or may be created by means of a vacuum or inert gas. The bending step is conducted in the same manner as described above, except that the bending oven is evacuated or filled with inert gas rather than being filled with a reducing gas.

Substantial reduction takes place during this bending step, and therefore it is not usually necessary to conduct the reduction curing step of Process I (step 11 in Figure 2), provided subsequent film oxidation is prevented. Thus step 11 is omitted from Process II and thus from Figure 3. The part resulting from Process II has a light transmittance before lamination of from about 78% to about 80%, a light absorption of from about 7% to about 10%, and a light reflectance of from about 12% to about 13%. The sheet resistance achieved in a full wave film is approximately 7 to 10 ohms per square sheet.

Process II has the advantage of using a conventional sputter coating step and eliminating the curing step. However, it is somewhat more difficult to conduct the bending step in a reducing environment. A special oven or the like is required.

In connection with Process II, under some circumstances, as for example if the coating is accidentally overreduced, some oxidation of the coated part may be necessary subsequent to the actual bending in order to achieve a sufficient degree of transparency. As the glass cools down after bending, some air may be reintroduced into the system to cause some reoxidation of the reduced coating.

While the method of coating described has been sputter coating other coating techniques to minimize crazing could also be used. Evaporation, pyrolytic deposition and chemical vapour deposition are alternative possible coating methods. Pyrolytic and chemical vapour deposition have the advantages of being operable at atmospheric pressure, whereas sputter coating and evaporation coating must be done in a vacuum. Variations to insuring substoichiometry at bend may be necessary due to peculiarities of such different coating techniques.

Thus the present invention provides, as exemplified by the above two processes, a bendable metallic oxide coated part on a commercially feasible basis, which will have sufficient conductivity to enable one to generate 930 $WN^{-2}$ (0.6 watts per square inch) at 60 volts for 0.635 m (25 inch) bus bar separations. The coating, such as an indium-tin oxide coating, has a slight degree of substoichiometry at the moment of bend so that no or substantially no crazing occurs on bending.

**Claims**

1. A process for making an electrically conductive bent substrate characterised by coating a generally flat part with indium tin oxide and subsequently bending the part while providing for at least sufficient oxygen substoichiometry at the moment of bend that there is substantially no crazing of the coating during bending, but not so great a substoichiometry that the final product has less than 70% light transmission, at an angle of 90° to the substrate, or is substantially hazy.

2. A process as claimed in Claim 1 in which the substoichiometry is achieved by exposing the indium tin oxide layer to a reducing environment as the substrate is heated to bend it.

3. A process as claimed in Claim 1 or 2 in which there is a reduction curing step in which the coated substrate is exposed to a reducing environment at a temperature in excess of 400°C.

4. A process for enhancing the electrical conductivity of an indium tin oxide coating coated on a substrate, characterised by first firing the coated substrate in atmosphere to a temperature in excess of about 500°C. but below the softening point of the glass, followed by bending the substrate, and heating the coating to a temperature greater than 400°C. in a reducing environment for a sufficient period of time to substantially lower the electrical resistance of the coating.

5. A process as claimed in any one of the preceding claims in which the substoichiometry is achieved by sputter coating a heated substrate with the indium tin oxide in a reduced oxygen environment to an initial light transmittance, at an angle of 90° to the substrate, of between 10 and 75%, and avoiding complete oxidation thereafter at least until after the substrate is bent.

6. A process as claimed in any one of Claims 1 to 3 in which the substoichiometry is achieved by sputter coating a substantially unheated substrate with the indium tin oxide in a reduced oxygen environment to an initial light transmittance, at an angle of 90° to the substrate, of between 10 and 40%, and avoiding complete oxidation thereafter at least until after the substrate is bent.

7. A process as claimed in any one of Claims 2 to 5 in which the substrate is coated to an initial light transmittance at an angle of 90° to the substrate in excess of about 40%.

8. A process as claimed in any one of the preceding claims in which the coated substrate is heated in an oxidizing environment sufficiently to lower the level of light absorption to between 1.7 and 10%.

9. A process as claimed in any one of Claims 2 to 8 in which the reduction step is performed for sufficient time to give the coating a specific resistivity of less than $3 \times 10^{-2}$ ohm metres ($3 \times 10^{-4}$ ohm cm).

10. A process as claimed in any one of the preceding claims in which the coating has a thickness of between one-half and three wavelengths based on the median wavelength of visible light, approximately 550 nm.

11. A process as claimed in any one of the preceding claims in which the substrate is glass and the bending step is conducted as typical heating and the bending step is conducted as typical heating and bending rates for such glass.

**Patentansprüche**

1. Verfahren zur Herstellung eines elektrisch leitfähigen gebogenen Substrats, gekennzeichnet durch Beschichten eines im wesentlichen flachen Teils mit Indium-Zinn-Oxid und nachfolgendes Biegen des Teils, während eine zumindest ausreichende Sauerstoff-Substöchiometrie zum Zeitpunkt des Biegens, so daß es während des Biegens im wesentlichen zu keiner Haarrißbildung des Überzugs kommt, aber eine nicht so große Substöchiometrie, daß das Endprodukt weniger als 70% Lichtdurchlässigkeit bei einem Winkel von 90° zum Substrat hat oder im wesentlichen getrübt ist, vorgesehen wird.

2. Verfahren nach Anspruch 1, worin die Substöchiometrie dadurch erreicht wird, daß die Indium-Zinn-Schicht einer reduzierenden Atmosphäre ausgesetzt wird, wenn das Substrat erhitzt wird, um es zu biegen.

3. Verfahren nach Anspruch 1 oder 2, worin ein Reduktionstemperschritt enthalten ist, bei dem das überzogene Substrat einer reduzierenden Atmosphäre bei einer Temperatur über 400°C ausgesetzt wird.

4. Verfahren zur Erhöhung der Leitfähigkeit eines auf einem Substrat aufgetragenen Indium-Zinn-Oxide-Überzugs, gekennzeichnet zuerst durch Aufheizen des überzogenen Substrats in der Luft auf eine Temperatur, die über ca. 500°C, aber unter der Erweichungstemperatur des Glases liegt, gefolgt vom Biegen des Substrats und dem Erhitzen des überzugs auf eine Temperatur über 400°C in einer reduzierenden Atmosphäre während einer Zeitspanne, die ausreichend ist, um den elektrischen Widerstand des Überzugs erheblich zu senken.

5. Verfahren nach einem der vorhergehenden Ansprüche, bei dem die Substöchiometrie durch Sputterbeschichten des Indium-Zinn-Oxids auf das erwärmte Substrat in einer reduzierten Sauerstoffatmosphäre zu einer anfänglichen Lichtdurchlässigkeit zwischen 10 und 75% bei einem Winkel von 90° zum Substrat und durch Vermeidung einer darauffolgenden vollständigen Oxidation zumindest bis nach dem Biegen des Substrats erreicht wird.

6. Verfahren nach einem der Ansprüche 1 bis 3, bei dem die Substöchiometrie durch Sputterbeschichten des Indium-Zinn-Oxids auf ein im wesentlichen nicht erwärmtes Substrat in einer reduzierten Sauerstoffatmosphäre zu einer anfänglichen Lichtdurchlässigkeit zwischen 10 und 40% bei einem Winkel von 90° zum Substrat und durch Vermeidung einer darauffolgenden vollständigen Oxidation zumindest bis nach dem Biegen des Substrats erreicht wird.

7. Verfahren nach einem der Ansprüche 2 bis 5, bei dem das substrat zu einer anfänglichen Lichtdurchlässigkeit von über 40% bei einem Winkel von 90° zum Substrat beschichtet wird.

8. Verfahren nach einem der vorhergehenden Ansprüche, bei dem das beschichtete Substrat in einer oxidierenden Atmosphäre ausreichend stark erhitzt wird, um das Niveau der Lichtabsorption auf einen Wert zwischen 1,7 und 10% zu senken.

9. Verfahren nach einem der Ansprüche 2 bis 8, bei dem der Reduktionsschritt während einer ausreichend langen Zeit durchgeführt wird, um dem Überzug einen spezifischen Widerstand von weniger als $3 \times 10^{-2}$ Ohm/Meter ($3 \times 10^{-4}$ Ohm/cm) zu geben.

10. Verfahren nach einem der vorhergehenden Ansprüche, bei dem der Überzug eine Dicke zwischen einer halben und drei Wellenlängen, basierend auf der mittleren Wellenlänge des sichtbaren Lichts, etwa 550 nm, hat.

11. Verfahren nach einem der vorhergehenden Ansprüche, bei dem das Substrat Glas ist und der Biegeschritt bei typischen Erwärmungs- und Biegeraten für ein derartiges Glas durchgeführt wird.

**Revendications**

1. Procédé pour fabriquer un substrat cintré conducteur, caractérisé en ce qu'on revêt une pièce dans l'ensemble plane d'oxyde d'indium et d'étain et on cintre ultérieurement la pièce, tandis qu'on assure une déficience stoechiométrique en oxygène au moment du cintrage qui soit au moins suffisante pour qu'en substance aucun fendillement du revêtement ne se produise pendant le cintrage, mais qui soit insuffisante pour que le produit final présente une transmission de lumière inférieure à 70%, sous an angle de 90° par rapport au substrat, ou soit en substance trouble.

2. Procédé suivant la revendication 1, dans lequel on réalise la déficience stoechiométrique en exposant la couche d'oxyde d'indium et d'étain à une ambiance réductrice lorsque le substrat est chauffé en vue de son cintrage.

3. Procédé suivant la revendication 1 ou 2, dans lequel un traitement thermique réducteur est prévu, au cours duquel le substrat revêtu est exposé à une ambiance réductrice à une température supérieure à 400°C.

4. Procédé pour augmenter la conductivité électrique d'un revêtement d'oxyde d'indium et d'étain appliqué sur un substrat, caractérisé en ce qu'on chauffe d'abord le substrat revêtu, à l'atmosphère, à une température supérieure à environ 500°C, mais inférieure au point de ramollissement du verre, puis on cintre le substrat et on chauffe le revêtement à une température supérieure à 400°C dans une ambiance réductrice pendant une période suffisante pour abaisser sensiblement la résistance électrique du revêtement.

5. Procédé suivant l'une quelconque des revendications précédentes, dans lequel on obtient la déficience stoechiométrique en revêtant par pulvérisation cathodique un substrat chauffé au moyen de l'oxyde d'indium et d'étain, dans une ambiance à teneur en oxygène diminuée, jusqu'à une transmission de lumière initiale, sous un angle de 90° par rapport au substrat, comprise entre 10 et 75% et en évitant ensuite une oxydation complète au moins jusqu'après le cintrage du substrat.

6. Procédé suivant l'une quelconque des revendications 1 à 3, dans lequel on obtient la déficience stoechiométrique en revêtant par pulvérisation cathodique un substrat en substance non chauffé au moyen de l'oxyde d'indium et d'étain, dans une ambiance à teneur en oxygène diminuée jusqu'à une transmission de lumière initiale, sous un angle de 90° par rapport au substrat, comprise entre 10 et 40%, et en évitant ensuite une oxydation complète au moins jusqu'après le cintrage du substrat.

7. Procédé suivant l'une quelconque de revendications 2 à 5, dans lequel le substrat est revêtu jusqu'à une transmission de lumière initiale, sous un angle de 90° par rapport au substrat, supérieure à environ 40%.

8. Procédé suivant l'une quelconque des revendications précédentes, dans lequel le substrat revêtu est chauffé, dans une ambiance oxydante, dans une mesure suffisante pour abaisser le degré d'absorption de lumière jusqu'à une valeur comprise entre 1,7 et 10%

9. Procédé suivant l'une quelconque des revendications 2 à 8, dans lequel l'opération de réduction est effectuée pendant un temps suffisant pour conférer au revêtement une résistivité spécifique inférieure à $3 \times 10^{-2}$ ohm-m ($3 \times 10^{-4}$ ohm-cm).

10. Procédé suivant l'une quelconque des revendications précédentes, dans lequel le revêtement a une épaisseur comprise entre une demi et trois longueurs d'onde, sur base de la longueur d'onde médiane de la lumière visible, qui est d'environ 550 nm.

11. Procédé suivant l'une quelconque des revendications précédentes, dans lequel le substrat est du verre et l'opération de cintrage est effectuée à des allures de chauffage et de cintrage typiques pour un tel verre.

Fig. 1.

Fig. 4.

0 108 616

| 1. SEAM & WASH THE GLASS | → | 2. SILK SCREEN BUS BARS | → | 3. FIRE BUS BARS |
| 6. SPUTTER COAT IN REDUCED $O_2$ ENVIRONMENT So $T_0$ IS REDUCED  ✱ | ← | 5. SILK SCREEN PERIPHERAL MASK. | ← | 4. WASH |
| 7. FIRE THE FILM | → | 8. WASH | → | 9. BEND THE COATED GLASS AND ITS MATE |
| 12. TEST RESISTANCE / TRANSMITANCE | ← | 11. REDUCTION CURE COATED PART AT 440 °C  ✱ | ← | 10. LABEL PARTS AND CLEAN |
| 13. SOLDER ON LEADS TO BUS BAR | → | 14. LAMINATE COATED PART TO MATE | → | 15. FINAL TEST |

PROCESS I

Fig. 2.

| SEAM & WASH THE GLASS 1. | → | SILK SCREEN BUS BARS 2 | → | FIRE BUS BARS 3. |

| SPUTTER COAT AS CONVENTIONAL 6. | ← | SILK SCREEN PERIPHERAL MASK 5 | ← | WASH 4. |

| FIRE THE FILM 7. | → | WASH 8. | → | BEND THE COATED GLASS AND ITS MATE IN A REDUCING ENVIRONMENT 9. * |

| TEST RESISTANCE AND TRANSMITANCE 12. | ← --- SKIP STEP 11. --- | LABEL PARTS AND CLEAN 10. |

| SOLDER ON LEADS TO BUS BAR 13. | → | LAMINATE COATED PART TO MATE 14. | → | FINAL TEST 15. |

PROCESS II

Fig. 3.